# EUROPÄISCHE PATENTSCHRIFT

(11) **EP 2 410 589 B1**
(45) Veröffentlichungstag und Bekanntmachung des Hinweises auf die Patenterteilung: **09.10.2013**
(21) Anmeldenummer: 10007663.7
(22) Anmeldetag: 23.07.2010
(51) Int. Cl.: H01L 43/12

(54) **Verfahren zur Herstellung eines TMR-Bauelements**
Method for producing a TMR construction element
Procédé de fabrication d'un composant TMR

(43) Veröffentlichungstag der Anmeldung: 25.01.2012
(73) Patentinhaber: Grützediek, Ursula, 55130 Mainz (DE); Scheerer, Jutta, 55130 Mainz (DE)
(72) Erfinder: Scheerer, Joachim Dr., 55130 Mainz (DE); Grützediek, Hartmut Dr., 55130 Mainz (DE)
(74) Vertreter: Oppermann, Frank

(56) Entgegenhaltungen:
- US-A1- 2009 085 058
- US-A1- 2009 200 264
- US-B1- 6 911 709

## Beschreibung

Die Erfindung betrifft ein Verfahren zur Herstellung eines TMR (Tunnel Magneto Resistance)-Bauelements.

Der magnetische Tunnelwiderstand (TMR) ist ein magneto-resistiver Effekt, der in magnetischen Tunnelkontakten (MTJ) auftritt. Bauelemente, die von dem Effekt des magnetischen Tunnelwiderstands Gebrauch machen, werden als TMR-Bauelemente bezeichnet.

Die bekannten TMR-Bauelemente zeichnen sich durch einen TMR-Schichtstapel aus, der eine erste ferromagnetische Schicht und eine zweite ferromagnetische Schicht aufweist, die von einer dünnen isolierenden Schicht getrennt sind. Wenn die isolierende Schicht dünn genug ist, beispielsweise nur einige Nanometer, so können Elektronen zwischen den ferromagnetischen Schichten tunneln. Beispiele finden sich in US 6911709, US2009/85058 und US2009/200264.

TMR-Bauelemente finden bspw. in modernen Festplatten-Laufwerken als Leseköpfe Verwendung. Auch bei Sensoren, bspw. ABS-Sensoren, in Kraftfahrzeugen kommen TMR-Bauelemente zum Einsatz. Nicht flüchtige Datenspeicher mit TMR-Bauelementen befinden sich in der Entwicklung.

Das Streben in der Computerindustrie nach immer weiterer Miniaturisierung erfordert neue Technologien für die Herstellung der TMR-Bauelemente. In der praktischen Anwendung ist nicht nur die Herstellung kleinster Strukturen eine Herausforderung, sondern als problematisch erweist sich auch die elektrische Kontaktierung der Strukturen. Hierbei stoßen die bekannten Herstellungsverfahren an ihre Grenzen.

Der Erfindung liegt die Aufgabe zugrunde, ein Verfahren anzugeben, mit dem TMR-Bauelemente in großen Stückzahlen kostengünstig hergestellt werden können. Eine Aufgabe der Erfindung ist insbesondere, ein Verfahren anzugeben, mit dem TMR-Bauelemente in Verbindung mit anderen elektronischen Bauelementen auf einem Halbleiterchip in großen Stückzahlen kostengünstig hergestellt werden können.

Die Lösung dieser Aufgabe erfolgt erfindungsgemäß mit den Merkmalen des Patentanspruchs 1. Vorteilhafte Ausführungsformen der Erfindung sind Gegenstand der Unteransprüche.

Das erfindungsgemäße Herstellungsverfahren für TMR-Bauelemente zeichnet sich durch einen zweistufigen Ätzprozess aus, bei dem in zwei aufeinanderfolgenden Schritten die einzelnen Schichten des TMR-Schichtstapels strukturiert werden.

Zunächst wird der TMR-Schichtstapel auf einen Träger abgeschieden. Dies kann mit den bekannten Verfahren erfolgen. Der TMR-Schichtstapel weist eine erste und zweite ferromagnetische Schicht auf, die von einer isolierenden Schicht getrennt sind. TMR-Schichtstapel mit einer derartigen Schichtfolge sind dem Fachmann bekannt. Auf der ersten ferromagnetischen Schicht befindet sich eine Kontaktschicht. Der TMR-Schichtstapel kann neben den oben genannten Schichten noch weitere Schichten aufweisen. Allein entscheidend ist, dass der TMR-Schichtstapel die oben genannten Schichten umfasst.

In dem ersten Schritt des zweistufigen Ätzprozesses wird nur die erste ferromagnetische Schicht des Schichtstapels geätzt bis die Isolationsschicht frei liegt, während in dem zweiten Schritt die Isolationsschritt und die zweite ferromagnetische Schicht geätzt werden. In dem zweiten Schritt können noch weitere Schichten geätzt werden, wenn der TMR-Schichtstapel neben den genannten Schichten noch weitere Schichten aufweisen sollte. Von Vorteil ist bei dem erfindungsgemäßen Verfahren, dass in dem ersten Schritt eine nur verhältnismäßig dünne Schicht des TMR-Schichtstapels entfernt zu werden braucht. Zwar erfordert das Ätzen ein sehr vorsichtiges Vorgehen, um nicht den empfindlichen Schichtübergang durch zu starken Ionenbeschuss zu belasten, was relativ viel Zeit kostet. Dies kann aber aufgrund der verhältnismäßig geringen Dicke der zu entfernenden Schicht in Kauf genommen werden. Bei dem zweiten Ätzschritt hingegen, ist der empfindliche Schichtübergang geschützt, so dass mit einem relativ starken Ionenbeschuss ohne die Gefahr der Belastung des Schichtübergangs geätzt werden kann. Da sich der zweite Ätzschritt prozesstechnisch einfach und gemessen an der Schichtdicke in einem relativ kurzen Zeitraum durchführen lässt, kann das TMR-Bauelement in großen Stückzahlen relativ schnell und kostengünstig hergestellt werden.

Ein weiterer entscheidender Vorteil des erfindungsgemäßen Verfahrens ist die Herstellung des TMR-Bauelements in Verbindung mit einem Halbleiterchip. Der TMR-Schichtstapel wird vorzugsweise auf einen Träger abgeschieden, der ein Substrat ist, in das Gräben geätzt werden, die mit einem leitfähigen Material gefüllt werden. Das leitfähige Material, für die Füllung der Gräben ist vorzugsweise Wolfram W oder Kupfer Cu. Das Substrat ist vorzugsweise ein Halbleiter, insbesondere Silizium, oder eine Metallisierung, wobei auf den Halbleiter oder die Metallisierung eine Isolationsschicht, insbesondere Siliziumdioxid abgeschieden wird, in die die Gräben geätzt werden. Die Oberfläche des Trägers wird vor dem Abscheiden des Schichtstapels chemisch-mechanisch poliert.

Das erfindungsgemäße Herstellungsverfahren erlaubt eine besonders einfache Kontaktierung des TMR-Bauelements dadurch, dass der TMR-Schichtstapel auf das leitfähige Material des Trägers abgeschieden wird. Mit dem leitfähigen Material, mit dem die Gräben des Trägers gefüllt werden, können bei einer entsprechenden Strukturierung Leiterbahnen unterschiedlicher Ausbildung geschaffen werden, die das TMR-Bauelement mit einem oder mehreren anderen Bauelementen auf dem Halbleiterchip elektrisch verbinden. Somit können auf dem Halbleiterchip (Substrat) neben dem TMR-Bauelement auch andere Bauelemente in großer Packungsdichte angeordnet werden.

Im Folgenden wird ein Ausführungsbeispiel der Erfindung unter Bezugnahme auf die Zeichnungen näher erläutert.

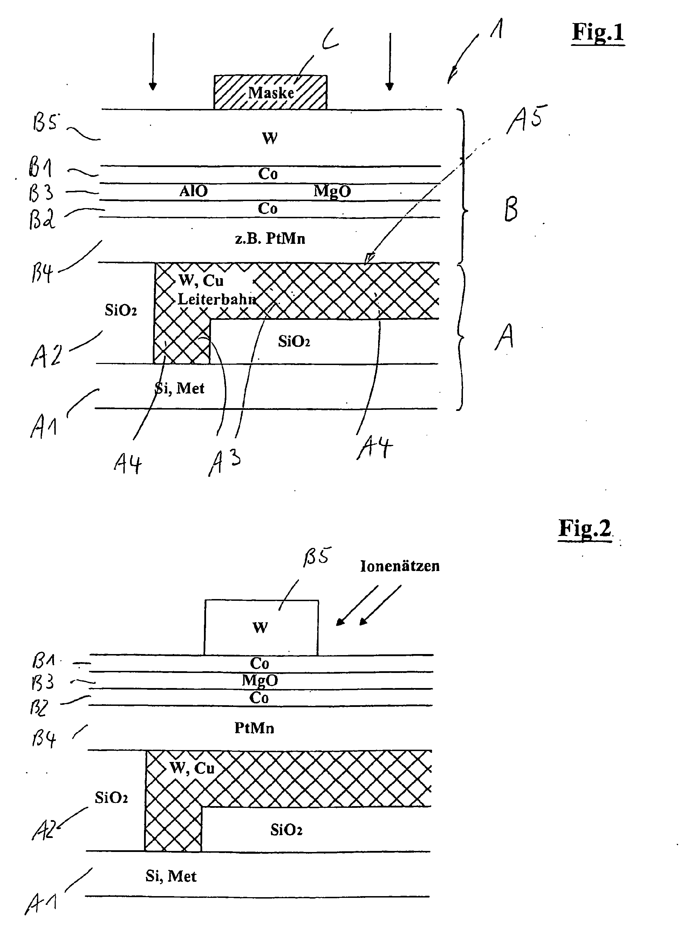

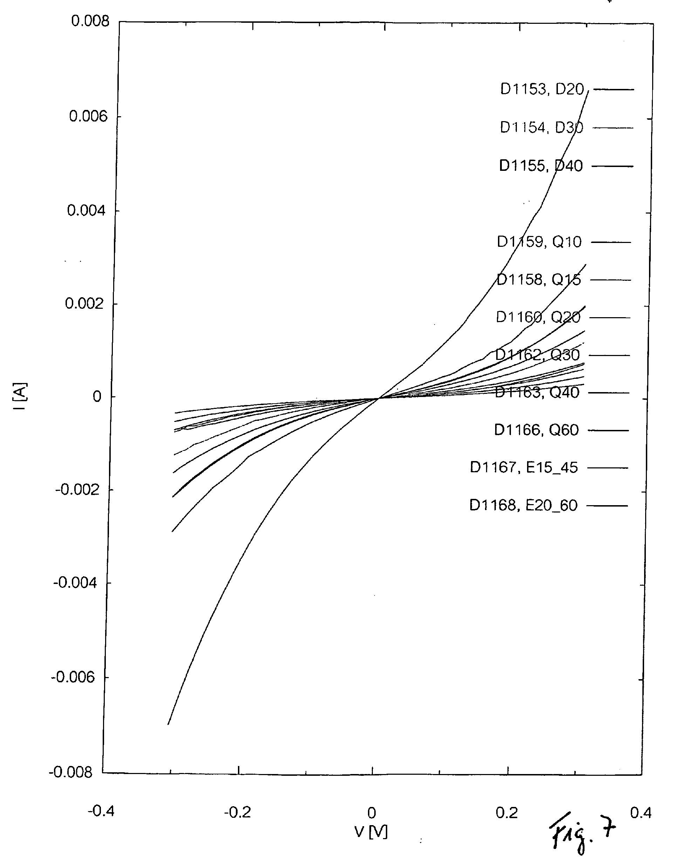

Die Fig. 1 - 6 zeigen einen Schnitt durch ein TMR-Bauelement in vereinfachter schematischer Darstellung während der einzelnen Schritte des erfindungsgemäßen Herstellungsverfahrens, und Fig. 7 zeigt die Strom-Spannungsabhängigkeit bei nach dem erfindungsgemäßen Verfahren hergestellten TMR-Bauelementen.

Fig. 1 zeigt einen Schnitt durch das TMR-Bauelement 1, das einen Träger A (Substrat) und einen TMR-Schichtstapel B umfasst.

Der Träger A und TMR-Schichtstapel B sind in Fig. 1 nur vereinfacht dargestellt. Fig. 1 zeigt nur den einfachsten Schichtstapel eines TMR-Bauelements. TMR-Bauelemente können noch weitere Schichten umfassen, die aber in Fig. 1 nicht dargestellt sind.

Der TMR-Schichtstapel B weist eine erste obere ferromagnetische Schicht B 1 und eine zweite untere ferromagnetische Schicht B2 auf, die von einer dünnen isolierenden Schicht B3 getrennt sind. Die erste und zweite ferromagnetische Schicht B1, B2 sind insbesondere Co-Schichten, während die Isolationsschicht B3 eine AlO oder MgO-Schicht ist.

Der TMR-Schichtstapel B umfasst eine weitere Schicht B4, insbesondere eine PtMn-Schicht, auf der die beiden ferromagnetischen Schichten B1, B2 und die Isolationsschicht B3 abgeschieden sind.

Zur Kontaktierung wird auf der ersten ferromagnetischen Schicht B1 eine elektrisch leitende Kontaktschicht B5 abgeschieden, die dem Anschluss des TMR-Bauelements dient. In der Patentanmeldung wird die Kontaktschicht 5 als eine der Schichten des TMR-Schichtstapels B des TMR-Bauelements angesehen.

Für die Herstellung des TMR-Bauelements in Verbindung mit dem Halbleiterchip wird zunächst der Träger A hergestellt. Der Träger A weist ein Halbleitersubstrat A1, insbesondere Silizium, oder eine Metallisierung auf, wobei auf den Halbleiter oder die Metallisierung eine Isolationsschicht A2, insbesondere eine Siliziumdioxidschicht, abgeschieden wird. In die Siliziumschicht A2 werden Gräben A3 geätzt, in denen ein leitfähiges Material A4, insbesondere Wolfram W oder Kupfer Cu abgeschieden wird. Das leitfähige Material A4 in den Gräbern A3 bildet eine Leiterbahn A5, die dem Anschluss des TMR-Bauelements dient. Die Leiterbahnen erlauben die elektrische Verbindung eines Anschlusses des TMR-Bauelements mit einem Anschluss eines oder mehrer anderer Bauelemente, die zusammen mit dem TMR-Bauelement auf dem Halbleiterchip in großer Packungsdichte hergestellt werden können.

Der Träger A wird an der Oberseite mit einem chemisch-mechanischen Polierverfahren geglättet. Hierzu findet das in der Waferbearbeitung zur gleichmäßigen Abtragung dünner Schichten bekannte CMP (Chemical Mechanical Polishing oder Chemical Mechanical Planarisation)-Polierverfahren Anwendung. Es hat sich in Versuchen gezeigt, dass der TMR-Schichtstapel B auf den mit dem bekannten Damascene-Prozess geglätteten Träger A großflächig abgeschieden werden kann. Der TMR-Schichtstapel B wird dabei für die spätere Kontaktierung des TMR-Bauelements auf dem Träger A über der Leiterbahn A5 abgeschieden.

Auf den TMR-Schichtstapel B wird eine Maske C aufgebracht, mit der die Kontur des TMR-Bauelements, bspw. des TMR-Sensors, definiert wird. Die Maske ist vorzugsweise eine Hartmaske, sie kann aber auch aus Fotolack bestehen.

Die Kontaktschicht B5, vorzugsweise W-Schicht des TMR-Bauelements wird in einem chemischen Ätzprozess, insbesondere anisotrop mit CF₄ geätzt, bis die erste ferromagnetische Schicht B1 frei liegt. Die erste ferromagnetische Schicht B1, vorzugsweise Co-Schicht, bildet einen Ätzstop für CF₄ und vermeidet eine Freilegung des Übergangs zwischen der ersten ferromagnetischen Schicht B1 und der Isolationsschicht B3.

Fig. 2 zeigt den Schichtaufbau nach dem Ätzen der Kontaktschicht B5 und dem Entfernen der Maske C. Die verbleibenden Schichten des TMR-Schichtstapels B, die das eigentliche TMR-Bauelement ausmachen, werden nunmehr in einem zweistufigen Prozess geätzt.

Die dünne obere ferromagnetische Schicht B1 wird mit Ionenstrahlen-Schrägsputtern entfernt, wobei der Ionenstrahl schräg auf die Oberfläche der ferromagnetischen Schicht B 1 des Schichtstapels B auftrifft. Das Ionenstrahl-Schrägsputtern erlaubt eine vorsichtige Entfernung der dünnen ersten ferromagnetischen Schicht B1, ohne den empfindlichen Übergang zwischen der ersten ferromagnetischen Schicht B1 und der Isolationsschicht B3 durch starken Ionenbeschuss zu belasten. Während des Schrägsputterns wird das Bauelement vorzugsweise gedreht. Es ist aber auch möglich, die Vorrichtung zum Schrägsputtern um das Bauelement zu drehen.

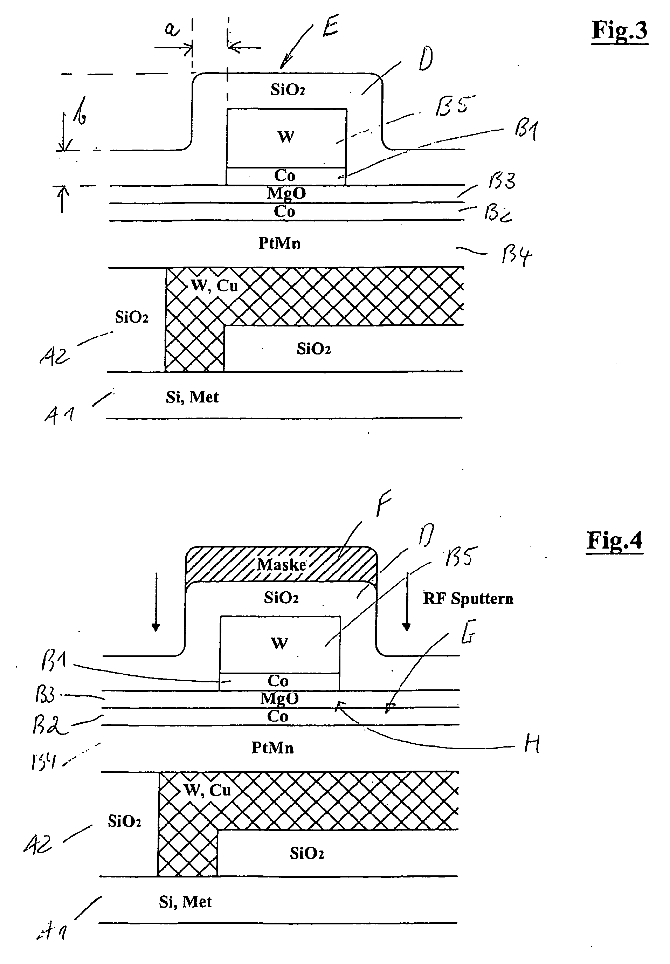

Nach dem ersten Prozessschritt liegt die Isolationsschritt B3 des Schichtstapels B frei (Fig. 3). Nunmehr werden die verbleibenden Schichten des TMR-Schichtstapels B in einem zweiten Prozessschritt entfernt, der nachfolgend beschrieben wird.

Auf der strukturierten Kontaktschicht B5 und der freiliegenden ersten ferromagnetischen Schicht B1 des Schichtstapels B wird großflächig eine dünne Schutzschicht D, insbesondere eine Siliziumdioxid-Schicht, abgeschieden, die beim nachfolgenden Ätzen als Schutz des empfindlichen Übergangs zwischen den ferromagnetischen Schichten und der Isolationsschicht dient. Beim Abscheiden der Schutzschicht D bildet sich ein vorspringender Absatz E, der sich über die äußeren Kanten der strukturierten Kontaktschicht B5 hinaus erstreckt. In Fig. 3 ist der Abstand zwischen der äußeren Kante des vorspringenden Absatzes E und der äußeren Kante der strukturierten Kontaktschicht B5 mit a bezeichnet. Die Schutzschicht D hat die Dicke b.

Auf die Oberseite des vorspringenden Absatzes E, der von der Schutzschicht D gebildet wird, wird eine Maske F aufgebracht, deren Überhang unkritisch ist (Fig. 4). Die Maske F kann auch über dem Stapel geöffnet sein. Auch ist ein maskenfreier Prozessschritt mit den bekannten Verfahren der Spacerbildung möglich, der sich in Versuchen aber deutlich kritischer erwiesen hat. Nach dem Aufbringen der Maske werden die verbleibenden Schichten des TMR-Schichtstapels B durch konventionelles Ionenstrahlen-Sputtern (RFsputtern) mit einem senkrecht auf die Oberfläche des Schichtstapels auftreffenden Ionenstrahl entfernt.

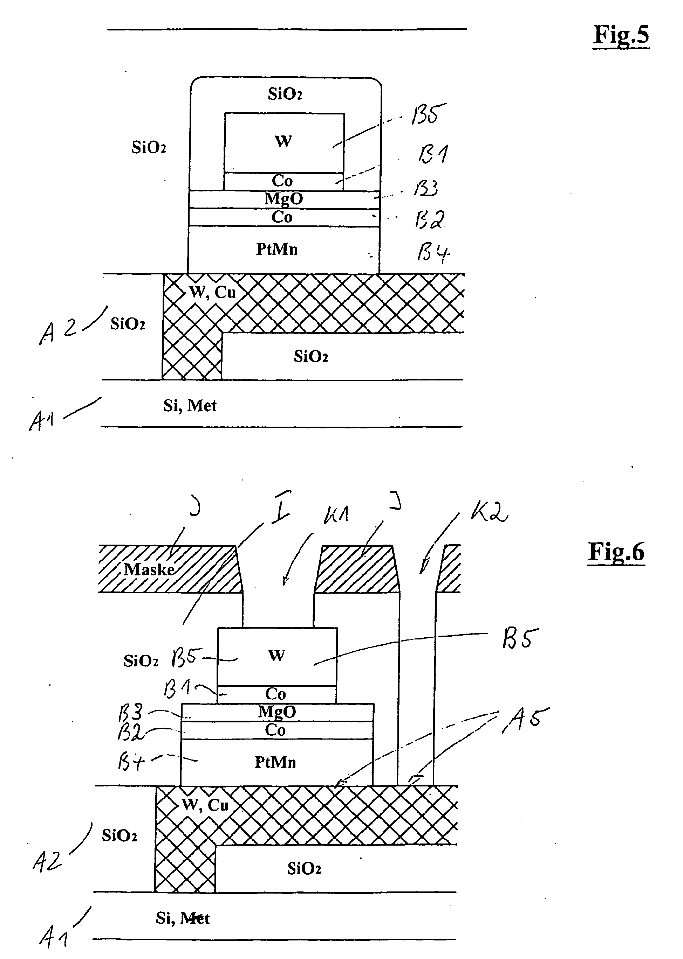

Fig. 5 zeigt den Schichtaufbau des TMR-Schichtstapels nach dem Entfernen der verbleibenden Schichten. Es zeigt sich, dass der empfindliche CoMgO-Übergang zwischen den ferromagnetischen Schichten und der Isolationsschicht durch den starken Ionenbeschuss beim RF-Sputterätzen nicht belastet wird, da der empfindliche CoMgO-Übergang durch die Schutzschicht D geschützt wird. Zwar wird der CoMgO-Übergang G im Bereich der äußeren Kante des TMR-Bauelements durch den starken Ionenbeschuss beim RF-Sputterätzen belastet, der innere CoMgO-Übergang H hingegen kann durch starken Ionenbeschuss nicht belastet werden (Fig. 4). Da sich die verbleibenden Schichten des TMR-Schichtstapels in kurzer Zeit mit dem RF-Sputterätzen prozesstechnisch einfach entfernen lassen, kann das TMR-Bauelement als solches in großen Stückzahlen kostengünstig insbesondere zusammen mit anderen Bauelementen auf einem Halbleiterchip hergestellt und mit den anderen Bauelementen kontaktiert werden.

Zum Schutz des TMR-Schichtstapels wird eine den Schichtstapel vollständig abdeckende Zwischenebenen-Isolationsschicht I, insbesondere eine Siliziumdixoidschicht, auf den Schichtstapel B und den Träger A abgeschieden. In der Zwischebenen-Ioslationsschicht I werden dann mit den bekannten Verfahren nach Aufbringen weiterer Masken J Fenster K für ein oder mehrere Anschlusskontakte geätzt. Fig. 6 zeigt zwei Fenster K1 und K2 für die beiden Anschlusskontakte des TMR-Bauelements. Die nicht dargestellten Anschlusskontakte können in den Fenstern mit den bekannten Verfahren hergestellt werden. Der eine Anschluss erfolgt an der Kontaktschicht B5, während der andere Anschluss an der Leiterbahn A5 erfolgt, die sich in dem Träger A seitlich über das TMR-Bauelement 1 hinaus erstreckt.

Nach dem erfindungsgemäßen Verfahren wurden verschiedene TMR-Bauelemente hergestellt. Der TMR-Schichtstapel eines dieser Bauelemente hat die nachfolgend beschriebene Schichtfolge:

| | |
|---|---|
| Ta | 5 nm |
| Pt Mn | 20 nm |
| Co75Fe | 3 nm |
| Ru | 0,8 nm |
| Co75Fe | 3 nm |
| AlOx | 1,0 nm |
| Co75Fe | 4 nm |
| TaN | 5 nm |

Für verschiedene TMR-Bauelemente mit dem oben angegebenen Schichtstapel wurden für unterschiedlich große Tunnel die Abhängigkeit des durch den Tunnel fließenden Stroms von der an dem Tunnel anliegenden Spannung gemessen. Eine Vormagnetisierung und Temperaturbehandlung wurde nicht durchgeführt. Es zeigt sich, dass mit dem beschriebenen Verfahren gute Ergebnisse erzielt werden.

## Patentansprüche

1. Verfahren zur Herstellung eines TMR-Bauelements mit folgenden Verfahrensschritten:
Abscheiden eines TMR-Schichtstapels (B) auf einen Träger (A), wobei der TMR-Schichtstapel eine erste ferromagnetischen Schicht (B1), eine isolierende Schicht (B3), eine zweite ferromagnetische Schicht (B3) und ein Kontaktschicht (B5) aufweist,
Aufbringen einer ersten Maske (C) auf die Kontaktschicht (B5) des Schichtstapels (B) zur Strukturierung der Kontaktschicht,
Ätzen der Kontaktschicht (B5) des Schichtstapels bis die erste ferromagnetische Schicht (B1) freiliegt,
Ionenstrahl-Sputtern der ersten ferromagnetischen Schicht (B1) des Schichtstapels mit einem schräg auf die Oberfläche des Schichtstapels auftreffenden Ionenstrahl bis die Isolationsschicht (B3) freiliegt,
Abscheiden einer Schutzschicht (D) auf der strukturierten Kontaktschicht (B5) und der freiliegenden Isolationsschicht (B3), wobei die Schutzschicht einen vorspringenden Absatz (E) bildet, der sich über die Kanten der Kontaktschicht erstreckt,
Ionenstrahl-Sputtern der Isolationsschicht (B3) und der zweiten ferromagnetischen Schicht (B2) des Schichtstapels mit einem senkrecht auf die Oberfläche des Schichtstapels auftreffenden Ionenstrahl bis auf den Träger.

2. Verfahren nach Anspruch 1, **dadurch gekennzeichnet, dass** vor dem Herunterätzen der isolierenden Schicht (B3) und der zweiten ferromagnetischen Schicht (B2) des Schichtstapels (B) eine zweite Maske (F) auf den vorspringenden Absatz (E) der Schutzschicht (D) aufgebracht wird.

3. Verfahren nach Anspruch 1 oder 2, **dadurch gekennzeichnet, dass** der Träger (A) ein Substrat ist, in das Gräben (A3) geätzt werden, die mit einem leitfähigen Material (A4) gefüllt werden.

4. Verfahren nach Anspruch 3, **dadurch gekennzeichnet, dass** das leitfähige Material (A4), mit dem die Gräben (A3) gefüllt werden, Wolfram W oder Kupfer Cu ist.

5. Verfahren nach einem der Ansprüche 1 bis 4, **dadurch gekennzeichnet, dass** das Substrat (A) ein Halbleiter (A1), insbesondere Silizium, oder eine Metallisierung (A1) aufweist, wobei auf den Halbleiter oder die Metallisierung eine Isolationsschicht (A2), insbesondere Siliziumdioxid, abgeschieden wird.

6. Verfahren nach einem der Ansprüche 1 bis 5, **dadurch gekennzeichnet, dass** die Oberfläche des Trägers (A) vor dem Abscheiden des TMR-Schichtstapels (B) chemisch-mechanisch poliert wird.

7. Verfahren nach einem der Ansprüche 1 bis 6, **dadurch gekennzeichnet, dass** der TMR-Schichtstapel (B) auf das leitfähige Material (A4) des Trägers (A) abgeschieden wird.

8. Verfahren nach einem der Ansprüche 1 bis 7, **dadurch gekennzeichnet, dass** die Schutzschicht (D) eine Siliziumdioxid-Schicht ist.

9. Verfahren nach einem der Ansprüche 1 bis 8; **dadurch gekennzeichnet, dass** die Kontaktschicht (B5) eine Wolframschicht ist.

10. Verfahren nach einem der Ansprüche 1 bis 9, **dadurch gekennzeichnet, dass** die Kontaktschicht (B5) anisotrop mit CF₄ geätzt wird.

11. Verfahren nach einem der Ansprüche 1 bis 10, **dadurch gekennzeichnet, dass** eine Zwischenebenen-Isolationsschicht (I) auf den Schichtstapel (B) abgeschieden wird.

12. Verfahren nach Anspruch 11, **dadurch gekennzeichnet, dass** ein oder mehrere Fenster (K1, K2) für einen oder mehrere Anschlusskontakte in die Zwischebenen-Isolationsschicht (I) geätzt werden.

## Claims

1. A method for producing a TMR component comprising the following method steps:
depositing a TMR layer stack (B) on a carrier (A), wherein the TMR layer stack includes a first ferromagnetic layer (B1), an insulating layer (B3), a second ferromagnetic layer (B2) and a contact layer (B5),
applying a first mask (C) on the contact layer (B5) of the layer stack (B) for patterning the contact layer,
etching of the contact layer (B5) of the layer stack until the first ferromagnetic layer (B1) is exposed,
ion-beam sputtering of the first ferromagnetic layer (B1) of the layer stack with an ion beam that impinges on the surface of the layer stack at an oblique angle until the insulation layer is exposed,
depositing a protective layer (D) on the patterned contact layer (B5) and on the exposed insulation layer (B3), wherein the protective layer forms a projecting shoulder (E) that extends over the edges of the contact layer,
ion-beam sputtering of the insulation layer (B3) and of the second ferromagnetic layer (B2) of the layer stack with an ion beam that impinges vertically on the surface of the layer stack all the way to the carrier.

2. The method according to Claim 1, **characterized in that**, prior to etching through the insulating layer (B3) and the second ferromagnetic layer (B2) of the layer stack (B), a second mask (F) is applied to the projecting shoulder (E) of the protective layer (D).

3. The method according to Claim 3, **characterized in that** the carrier (A) is a substrate into which trenches (A3) are etched that are filled with a conductive material.

4. The method according to Claim 3, **characterized in that** the conductive material (A4), which is used for filling the trenches (A3), is tungsten W or copper Cu.

5. The method according to any one of the Claims 1 to 4, **characterized in that** the substrate (A) includes a semiconductor (A1), particularly silicon, or a metallization (A1), wherein an insulation layer (A2) is deposited on the semiconductor or the metallization, particularly of silicon dioxide.

6. The method according to any one of the Claims 1 to 5, **characterized in that** the surface of the carrier (A) is polished by chemical-mechanical means prior to depositing the TMR layer stack (B).

7. The method according to any one of the Claims 1 to 6, **characterized in that** the TMR layer stack (B) is deposited on the conductive material (A4) of the carrier (A).

8. The method according to any one of the Claims 1 to 7, **characterized in that** the protective layer (D) is a silicon dioxide layer.

9. The method according to any one of the Claims 1 to 8, **characterized in that** the contact layer (B5) is a tungsten layer.

10. The method according to any one of the Claims 1 to 9, **characterized in that** the contact layer (B5) is etched anisotropically using CF₄.

11. The method according to any one of the Claims 1 to 10, **characterized in that** an intermediate level insulation layer (I) is deposited on the layer stack (B).

12. The method according to any one of the Claims 1 to 11, **characterized in that** one or a plurality of windows (K1, K2) is/are etched in the intermediate level insulation layer (I) for one or a plurality of terminal contacts.

## Revendications

1. Procédé de fabrication d' un composant TMR, comprenant les étapes de procédé suivantes :
dépôt d' une pile de couches TMR (B) sur unsupport (A), la pile de couches TMR présentant une première couche ferromagnétique (B1), une couche isolante (B3), une deuxième couche ferromagnétique (B3) et une couche de contact (B5),
application d' un premier masque (C) sur la couche de contact (B5) de la pile de couches (B) pour la structuration de la couche de contact,
gravure de la couche de contact (B5) de la pile de couches jusqu' à ce que la première couche ferromagnétique (B1) soit dégagée,
bombardement ionique de la première couche ferromagnétique (B1) de la pile de couches avec un faisceau ionique frappant obliquement la surface de la pile de couches jusqu' à ce que la couche isolante (B3) soit dégagée,
dépôt d' une couche de protection (D) sur la couche de contact (B5) structurée et la couche isolante (B3) dégagée,la couche de protection formant un épaulement (E) en saillie qui s' étend sur les arêtes de la couche de contact,
bombardement ionique de la couche isolante (B3) et de la deuxième couche ferromagnétique (B2) de la pile de couches jusqu' au support avec un faisceau ionique frappant perpendiculairement la surface de la pile de couches.

2. Procédé selon la revendication 1, **caractérisé en ce que**, avant la gravure descendante de la couche isolante (B3) et de la deuxième couche ferromagnétique (B2) de la pile de couches (B), un deuxième masque (F) est appliqué sur l'épaulement (E) en saillie de la couche de protection (D).

3. Procédé selon la revendication 1 ou 2, **caractérisé en ce que** le support (A) est un substrat dans lequel sont gravées des tranchées (A3) qui sont remplies d' un matériau conducteur (A4).

4. Procédé selon la revendication 3, **caractérisé en ce que** le matériau conducteur (A4) dont les tranchées (A3) sont remplies est du tungstène W ou du cuivre Cu.

5. Procédé selon une des revendications 1 à 4, **caractérisé en ce que** le substrat (A) présente un semi-conducteur (A1), en particulier du silicium, ou une métallisation (A1), une couche isolante (A2), en particulier du dioxyde de silicium, étant déposée sur le semi-conducteur ou sur la métallisation.

6. Procédé selon une des revendications 1 à 5, **caractérisé en ce que** la surface du support (A) est polie par voie chimico-mécanique avant le dépôt de la pile de couches TMR (B).

7. Procédé selon une des revendications 1 à 6, **caractérisé en ce que** la pile de couches TMR (B) est déposée sur le matériau conducteur (A4) du support (A).

8. Procédé selon une des revendications 1 à 7, **caractérisé en ce que** la couche de protection (D) est une couche de dioxyde de silicium.

9. Procédé selon une des revendications 1 à 8, **caractérisé en ce que** la couche de contact (B5) est une couche de tungstène.

10. Procédé selon une des revendications 1 à 9, **caractérisé en ce que** la couche de contact (B5) est gravée de façon anisotrope avec du CF₄.

11. Procédé selon une des revendications 1 à 10, **caractérisé en ce qu'** une couche isolante de plan intermédiaire (I) est déposée sur la pile de couches (B).

12. Procédé selon la revendication 11, **caractérisé en ce qu'** une ou plusieurs fenêtres (K1, K2) pour un ou plusieurs contacts de connexion sont gravées dans la couche isolante de plan intermédiaire (I).
